# EUROPEAN PATENT APPLICATION

(11) **EP 1 313 140 A1**
(43) Date of publication of application: **21.05.2003**
(21) Application number: 02257542.7
(22) Date of filing: 30.10.2002
(51) Int. Cl.: H01L 21/768

(54) **Method of forming a liner for tungsten plugs**

(30) Priority: 15.11.2001 US 999285
(71) Applicant: Agere Systems Inc., Allentown, PA 18109 (US)
(72) Inventor: Bhowmik, Siddhartha, Allentown, PA 18104 (US); Patel, Minesh Amrat, Orlando, FL32835 (US); Merchant, Sailesh Mansinh, Orlando, FL 32835 (US); Darrell,L. Simpson, Gotha, FL 34734 (US)
(74) Representative: Williams, David John

(57) **Abstract**

A liner and method of forming a liner for a tungsten plug in a semiconductor device which reduces cost and improves reliability. In one aspect, it has been discovered that by depositing an initial film of titanium using any conventional process such as CVD, PVD or IMP (ion metal plasma) and then heating the device in a nitrogen atmosphere to a temperature of about 450 degrees C, a thin protective layer of titanium nitride can be form on the surface of the initial film. The protective layer has been found to be uniform in density and avoids the irregularities occurring in deposited titanium nitride. The thickness of the TiN layer can be controlled by controlling the time duration of the annealing process and by controlling the pressure of the nitrogen in the annealing tool. Using this two step method, the integrity of the titanium nitride layer is preserved and the formation of volcanoes is avoided.

## Description

This disclosure relates generally to the manufacture of semiconductor devices having a multilayer interconnection structure and, more particularly, to a novel liner and method of making a liner for use with tungsten plugs in such devices.

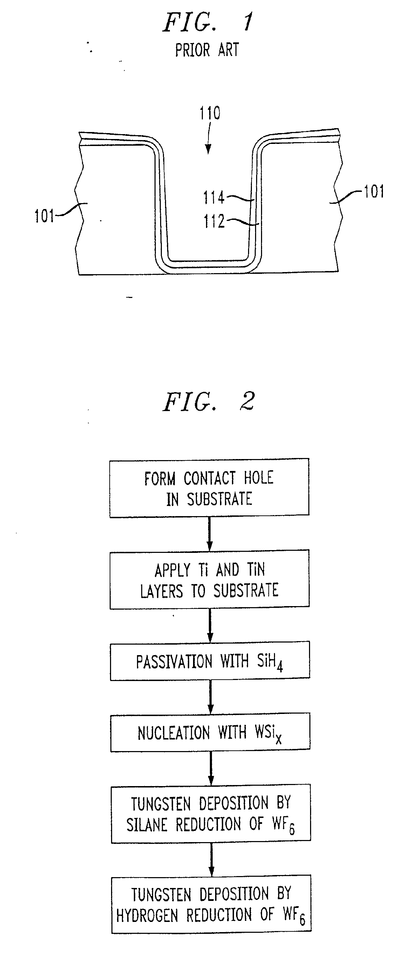

In the manufacture of a conventional tungsten plug or stud, a substrate 101 has a contact hole 110 formed therein as shown in FIG. 1. A liner comprising a titanium (Ti) layer 112 and a titanium nitride (TiN) layer 114 are sequentially deposited on the substrate. Tungsten is then deposited, for example via chemical vapor deposition using tungsten hexaflouride, to fill contact hole 110. Depending on the position of the substrate within the device, the structure shown in FIG. 1 can be used to produce a tungsten plug at the window level or a tungsten plug at the via level.

The process of forming the titanium (Ti) layer and the subsequent deposition of the titanium nitride (TiN) layer over the Ti layer represents a substantial cost in the manufacturing process. Further, there are reliability issues with the deposition of TiN including high defect density in deposited TiN. In conventional processing, a semiconductor wafer is placed in a tool and subjected to processing using physical vapor deposition (PVD) or chemical vapor deposition (CVD) for depositing a thin film or layer of titanium as an adhesion layer between an underlying conductor layer, typically aluminum, and the tungsten plug in vias. It is necessary to overlay the Ti with a nitrided barrier layer to prevent migration of the tungsten hexaflouride (WF₆) through the adhesive layer. The barrier layer is formed by deposition of Ti in a nitrogen atmosphere to form TiN using a sputtering technique well known in the art. Defects in the barrier layer may allow migration of fluorine into pinholes and rupture of the TiN causing "volcanoes" and other aberrant growth of the tungsten plug.

The present invention discloses a liner and method of forming a liner for a tungsten plug in a semiconductor device which reduces cost and improves reliability. In one aspect, it has been discovered that by depositing an initial film of titanium using any conventional process such as CVD, PVD or IMP (ion metal plasma) and then heating the device in a nitrogen atmosphere to a temperature of about 450 degrees C, a thin protective layer of titanium nitride can be form on the surface of the initial film. The protective layer has been found to be uniform in density and avoids the irregularities occurring in deposited titanium nitride. The thickness of the TiN layer can be controlled by controlling the time duration of the annealing process and by controlling the pressure of the nitrogen in the annealing tool. Using this two step method, the integrity of the titanium nitride layer is preserved and the formation of volcanoes is avoided. While the invention is preferably implemented using Ti, it is believed that other refractory metals such as tantalum and tungsten may also be suitable with this method.

Various embodiments are described herein with reference to the drawings, wherein:
FIG. 1 is a schematic representation of a structure having a tungsten plug using conventional, prior art techniques;
FIG. 2 is a flow diagram showing the steps for forming a tungsten plug in accordance with a conventional method;
FIG. 3 is a more detailed schematic representation of a conventional tungsten plug semiconductor structure;
FIG. 4 is a flow diagram showing the steps of the present invention in one form; and
FIG. 5 is a schematic representation of a liner formation using the present invention.

FIG. 2 is a flow diagram summarizing the steps in one known method of forming a liner for a tungsten plug. First, a contact hole is formed in the insulator layer of a substrate to expose a portion of a conductive layer or active layer of the device on which the insulator layer has been deposited. Next, titanium and titanium nitride layers are applied to the substrate. The coated substrate is then optionally subjected to rapid thermal annealing. Next, the coated substrate is passivated by contact with SiH₄. Then a nucleation or seed layer of WSiₓ is applied by silane reduction of tungsten hexafluoride at a relatively low pressure, followed by tungsten deposition by silane reduction of tungsten hexafluoride. Finally, the contact hole is at least substantially filled with tungsten by hydrogen reduction of tungsten hexafluoride at relatively high pressures.

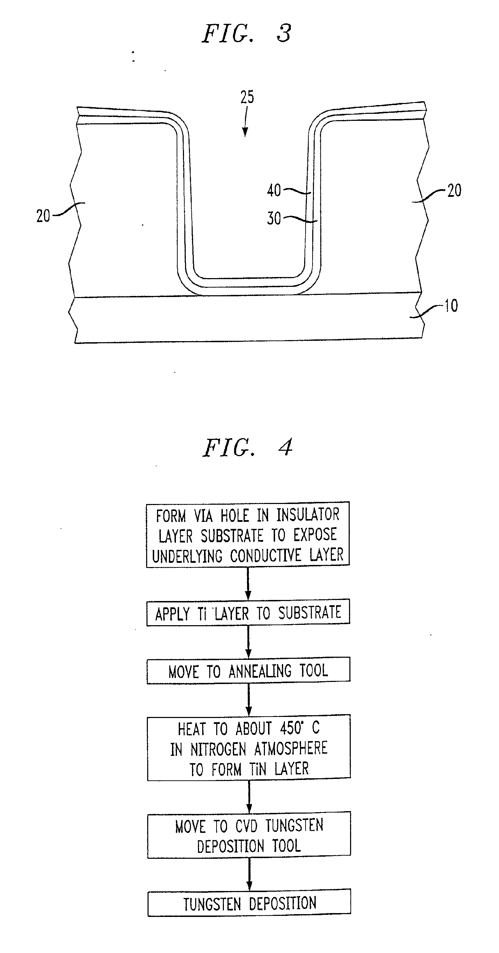

FIG. 3 illustrates in more detail a substrate for forming a layered semiconductor device including a first conductive layer 10 and an insulator layer 20 in a prior art method. Insulator layer 20 can be made from any typical and well-known dielectric material used in wafer fabrication. A contact hole or via 25 extending down to the first conductive layer 10 is formed in insulator layer 20 using conventional photolithographic techniques. A titanium film 30 is deposited on the exposed surfaces. Titanium film 30 can be applied, for example, using a vacuum deposition technique such as sputtering. The thickness of the titanium film is generally about 500 to 600 Angstroms. A titanium nitride (TiN) film 40 is deposited on all exposed surfaces of titanium film 30. Titanium nitride (TiN) film 40 is formed using a reactive sputtering process with a Ti target in an argon and nitrogen atmosphere. The thickness of titanium nitride film 40 is typically in the range of about 600 to 1200 Angstroms. The TiN film 40 serves as an adhesion layer, facilitating deposition of tungsten onto the substrate.

In one prior art process for contact windows, before the tungsten deposition process, the titanium/titanium nitride coated substrate is subjected to rapid thermal annealing (RTA) by exposing the coated substrate to temperatures of between 650 about degrees. to 700 degrees C for a period of time ranging from 5 to 60 seconds in an attempt to reduce pin hole defects in the TiN layer.

After annealing, the TiN surface is passivated by exposure to silane (SiH₄) gas to produce a layer of silicon on the titanium nitride layer. Following passivation, a nucleation layer is formed by WF₆ reduction by SiH₄ at relatively low pressures. The nucleation step is believed to provide a WSiₓ seed layer on the passivated TiN surface. The relative flow rates of SiH₄ and WF₆ are then adjusted to initiate the tungsten deposition. The conditions suitable for tungsten deposition by silane reduction of tungsten hexafluoride are known to those skilled in the art. Tungsten deposition is continued for a period of time sufficient to substantially fill the contact hole with a tungsten plug 60 during which time a layer 70 of tungsten is deposited on the upper surface of the structure. A polishing step such as CMP is thereafter used to remove the tungsten layer while leaving the tungsten plug in place.

The present invention addresses the pinhole defects and other issues associated with deposition of the TiN adhesion layer in semiconductor wafer processing. As shown in FIG. 4, in a process in accordance with this invention, the initial deposition of an adhesion layer in a via, such as via 25 of FIG. 3, can be accomplished using any of the known deposition techniques such as, for example, chemical vapor deposition (CVD), physical vapor deposition (PVD), ion metal plasma process (IMP) as well as others. The deposition process is carried out in a conventional tool and the adhesion layer can be titanium (Ti) or tantalum (Ta) having a thickness of between about 100 to 600 Angstroms when using PVD or IMP. Those skilled in the art will recognize that these thicknesses will be substantially lower for CVD. Following deposition of the adhesion layer, the wafer is moved from the deposition tool to an annealing tool. It will be noted that at this time, there has not been any deposition of a TiN barrier layer. In the annealing tool, the wafer is subjected to heating to a temperature of between about 300 degrees C and about 450 degrees C in a nitrogen atmosphere. Applicants have discovered that heating at this relatively low temperature is sufficient to cause a physical absorption of the nitrogen into an outer surface of the adhesion layer to form a titanium nitride barrier layer. The thus formed barrier layer is uniform and does not suffer from the pinhole effects common to barrier layers formed by deposition such as described above. The barrier layer is typically about 20 angstroms in thickness. However, the thickness of the layer can be increased by lengthening the time and exposure to nitrogen atmosphere in the annealing tool. It is also believed that the barrier layer thickness can be increased by pressurizing the annealing tool so that the nitrogen is forced into the adhesion layer.

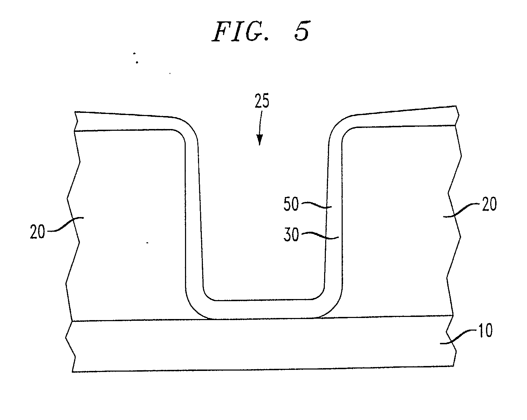

Once a sufficient thickness barrier layer has been formed on the adhesion layer, the wafer can be removed from the annealing tool and returned to a deposition tool for further processing in the same or similar manner as described above in order to deposit the tungsten into the vias or trenches on the wafer surface. The resulting semiconductor structure is substantially as shown in FIG. 5 with the thin barrier layer 50. It is also possible that the physio-absorbed nitrogen creates a bond that is distinctive when compared to the bonds of the sputtered barrier layer of TiN as shown in FIG. 3.

Another advantage of the present inventive method is that the nitride barrier layer is formed at temperatures that are generally low enough not to be detrimental to the wafer and other layers on the wafer. For example, the temperature of 450 degrees C is well below a temperature that will melt or otherwise damage aluminum. This is advantageous since aluminum is commonly used for conductors at different levels of the semiconductor structure and has a melting point of about 660 degrees C. Therefore the present invention can be used advantageously at the via level where a low thermal budget is required for processing these wafers and those skilled in the art will recognize that it can be applied at the contact level as well.

It will be recognized that a refractory metal such as Ti is commonly used in the manufacture of adhesion and barrier layers in semiconductor devices.

Applicants believe that tantalum (Ta) and tungsten (W) may also be used for such layers by employing the nitride formation techniques of the present invention. Accordingly, while the invention has been described with reference to what is considered to be a preferred embodiment, it is intended that the invention not be limited to the specific disclosed embodiment but be interpreted within the full spirit and scope of the appended claims.

## Claims

1. A liner for tungsten plugs comprising:
an initial film of a refractory metal; and
a nitrided layer formed within an outer surface of said film.

2. The liner of claim 1 wherein the initial film has a thickness between about 100 and 600 angstroms.

3. The liner of claim 2 wherein the nitrided layer has a thickness of at least about 20 angstroms.

4. The liner of claim 1 wherein the initial film comprises a metal film deposited by one of IMP, CVD and PVD.

5. The liner of claim 1 wherein the refractory metal comprises titanium.

6. The liner of claim 1 wherein the refractory metal comprises tantalum.

7. The liner of claim 1 wherein the refractory metal comprises tungsten.

8. The liner of claim 4 wherein the nitrided layer comprises a physio-absorbed layer formed by annealing the initial film at a temperature less than about 450°C.

9. The liner of claim 1 wherein the initial film acts as an adhesive layer.

10. A method for forming a liner for a tungsten plug comprising:
depositing an initial film of a refractory metal; and
annealing the initial film in a nitrogen atmosphere to form a nitrided layer within the film.

11. The method of claim 10 wherein the step of depositing comprises one of IMP, CVD and PVD.

12. The method of claim 10 wherein the step of annealing comprises heating of the initial film in a nitrogen atmosphere.

13. The method of claim 12 wherein the step of heating comprises heating of the film to a temperature between about 300° C and 450° C.

14. The method of claim 13 wherein pressure during the annealing step is controlled to establish a thickness of the nitrided layer.

15. The method of claim 10 wherein the refractory metal comprises titanium and the step of annealing forms a titanium nitride layer.

16. The method of claim 10 wherein the refractory metal comprises tantalum and the step of annealing forms a tantalum nitride layer.

17. The method of claim 10 wherein the refractory metal comprises tungsten and the step of annealing forms a tungsten nitride layer.

18. The method of claim 15 wherein the step of annealing comprises heating of the titanium in a nitrogen atmosphere for a time sufficient to establish a titanium nitride layer of at least 20 angstroms thickness.
